# EUROPEAN PATENT APPLICATION

(11) **EP 2 293 349 A1**
(43) Date of publication of application: **09.03.2011**
(21) Application number: 08777522.7
(22) Date of filing: 23.06.2008
(51) Int. Cl.: H01L 31/052, H01L 31/068

(54) **PHOTOVOLTAIC SYSTEM AND METHOD FOR MANUFACTURING THE SAME**

(71) Applicant: Mitsubishi Electric Corporation, Tokyo 100-8310 (JP)
(72) Inventor: MORIKAWA, Hiroaki, Tokyo 100-8310 (JP)
(74) Representative: Pfenning, Meinig & Partner GbR
(86) International application number: PCT/JP2008/061411
(87) International publication number: WO 2009/157053

(57) **Abstract**

To obtain a photovoltaic device having a structure to use reflection light at a back surface side of the photovoltaic device. The photovoltaic device includes a p-type silicon substrate 12, an n-type diffusion layer 13 having an n-type impurity diffused at a light incident-surface side of the p-type silicon substrate 12, front surface electrodes formed on the n-type diffusion layer 13, a p+ layer 14 formed on a back surface opposite to the light incident-surface side of the p-type silicon substrate 12, back-surface silver electrodes 18 formed at predetermined positions of the p+ layer 14, and a reflection layer 20 made of an insulating material that reflects light formed on the p+ layer 14 on which back-surface silver electrodes 18 are formed.

## Description

### TECHNICAL FIELD

The present invention relates to a photovoltaic device and a method for manufacturing the same.

### BACKGROUND ART

The mainstream of solar batteries for power generation currently used on the earth are silicon solar batteries. A process flow of solar batteries at a mass production level is generally simplified as far as possible in order to reduce manufacturing costs. An example of a conventional manufacturing method of silicon solar batteries is explained below. A silicon nitride film is formed as a reflection prevention film on a surface at a light receiving surface side of a p-type silicon substrate on which an n-type diffusion layer is formed by thermally diffusing phosphorus (P) or the like. Thereafter, an aluminum paste and a back-surface silver paste are coated on a back surface by a screen printing method, and are sequentially dried. Further, a silver paste is coated by the screen printing method on the reflection prevention film at the light receiving surface side, and is dried. These coated and dried pastes are sintered at 700°C to 900°C. As a result, at a back surface side, aluminum is diffused in high concentration from the aluminum paste into the silicon substrate, thereby forming a p+ layer generally called a BSF (Back Surface Field) layer. On an upper surface of the p+ layer, back-surface aluminum electrodes are formed by sintering the aluminum paste, and back-surface silver electrodes are formed by sintering the back-surface silver paste. A boundary between the back-surface aluminum electrode and the back-surface silver electrode becomes in an alloy state at this sintering time, and these electrodes are electrically connected. The back-surface aluminum electrodes are formed on the entire back surface of the silicon substrate, and the back-surface silver electrodes are partially formed at predetermined positions of the back surface of the silicon substrate. Meanwhile, at the light receiving surface side, front-surface silver electrodes electrically contacted to the n-type diffusion layer penetrating the reflection prevention film are formed. A solar cell is formed as described above (see, for example, Patent Document 1). Thereafter, the front-surface silver electrodes of the solar cell and the back-surface silver electrodes of another solar cell are connected by tab electrodes, and plural cells are connected in series, thereby forming a module.

However, in a solar cell formed in this manner, a reflectance of the back-surface aluminum electrodes that reflect light incident from the light receiving surface side to the light receiving surface side is about 60%, and the light incident to the solar cell cannot be efficiently used. Therefore, to increase the reflectance at the back surface and to effectively use light incident to the solar cell, there has been conventionally proposed a solar battery with a structure having a light-reflection electrode layer made of silver or copper in a higher reflectance than that of aluminum provided on the entire surface of a p+ layer, by removing the back-surface aluminum electrodes formed on the p+ layer (see, for example, Patent Document 2).

Patent Document 1: Japanese Patent Application Laid-open No. 2004-207493
Patent Document 2: Japanese Patent Application Laid-open No. H5-129640

### DISCLOSURE OF INVENTION

### PROBLEM TO BE SOLVED BY THE INVENTION

To manufacture a solar battery described in Patent Document 2, an aluminum film for forming a p+ layer is formed on the back surface, and is sintered to form the p+ layer. An aluminum layer remaining without being diffused is removed by a mixed liquid of hydrofluoric acid, hydrochloric acid, and nitric acid, and a light-reflection electrode layer of silver or copper is formed by an evaporation method or a sputtering method. However, when a metal is immersed into a mixed liquid of hydrofluoric acid, hydrochloric acid, and nitric acid, the metal is usually etched. Therefore, the method of Patent Document 1 mentioned above cannot be directly used to form a front-surface silver electrode, and the following method is necessary. For example, the light receiving surface side is protected by a mask material having resistance against the mixed liquid, and the mask material at the light-receiving side is removed after removing the aluminum layer from the back surface. Alternatively, a p+ layer is formed at only the back surface side in a state that an electrode is not formed on the light receiving surface. Thereafter, the aluminum layer at the back surface side is removed. A front-surface silver electrode at the light receiving surface side needs to be formed by printing and sintering again.

As explained above, while a solar battery of a structure having a back aluminum electrode can have front-surface and back-surface electrodes formed by one sintering, a solar battery of a structure having a light-reflection electrode layer formed on a back surface includes a process of removing only an aluminum layer necessary to form a p+ layer on the back surface by leaving other silver electrode as it is, and has a problem that the number of processes is increased. Further, because a metal material such as silver and copper is used to form a light-reflection electrode layer, an expensive vacuum fixture such as a deposition apparatus and a sputtering device taking time to form a film needs to be used. As compared with the method described in Patent Document 1, it takes time and cost to form a film.

The present invention has been achieved in view of the above problems, and an object of the present invention is to obtain a photovoltaic device having a structure to use reflection light at a back surface side of the photovoltaic device. Another object of the present invention is to obtain a method for manufacturing a photovoltaic device with an improved reflectance of light at a back surface side by suppressing time and cost without greatly increasing the number of processes as compared with a method using a back-surface aluminum electrode when the photovoltaic device is manufactured.

### MEANS FOR SOLVING PROBLEM

In order to achieve the above-mentioned object, a photovoltaic device according to the present invention comprising: a first conductivity-type semiconductor substrate; a first diffusion layer having a second conductivity-type impurity diffused at a light incident surface side of the semiconductor substrate; a front surface electrode formed on the first diffusion layer; a second diffusion layer of a first conductivity type formed on a back surface opposite to a light incident surface side of the semiconductor substrate; back-surface electrodes formed at predetermined positions on the second diffusion layer; and a reflection layer made of an insulating material that reflects light formed on the second diffusion layer on which the back-surface electrodes are formed.

### EFFECT OF THE INVENTION

According to the present invention, a reflection layer having a higher reflectance than that in a conventional structure on a back surface in a long wavelength of equal to or more than 1,000 nanometers is provided. Therefore, a proportion of light transmitted through a semiconductor layer part without being absorbed and reflected by a reflection layer becomes larger than that of a conventional structure, and thus power generation efficiency can be increased.

### BRIEF DESCRIPTION OF DRAWINGS

FIG. 1-1 is a plan view of an example of a solar cell according to a first embodiment of the present invention.
FIG. 1-2 is a back surface view of the solar cell in FIG. 1-1.
FIG. 2 is a cross-sectional view along a line A-A in FIG. 1-1.
FIG. 3-1 is a cross-sectional view (1) schematically depicting an example of a method for manufacturing a solar cell according to the first embodiment of the present invention.
FIG. 3-2 is a cross-sectional view (2) schematically depicting an example of a method for manufacturing a solar cell according to the first embodiment of the present invention.
FIG. 3-3 is a cross-sectional view (3) schematically depicting an example of a method for manufacturing a solar cell according to the first embodiment of the present invention.

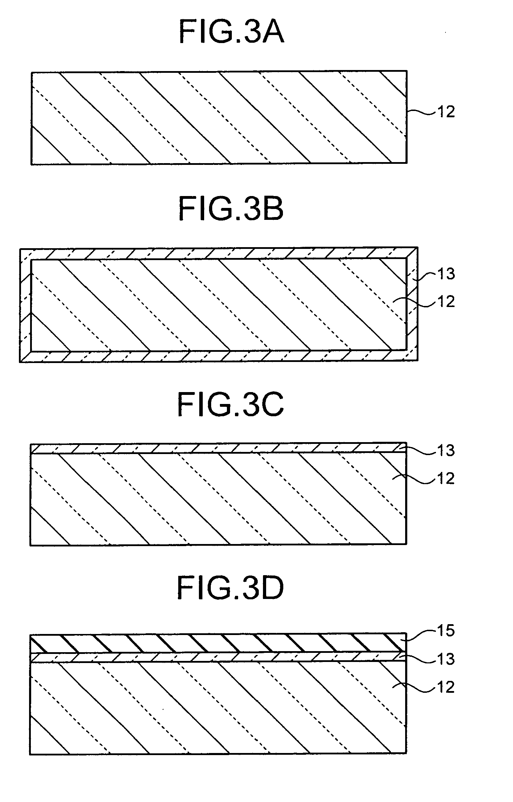

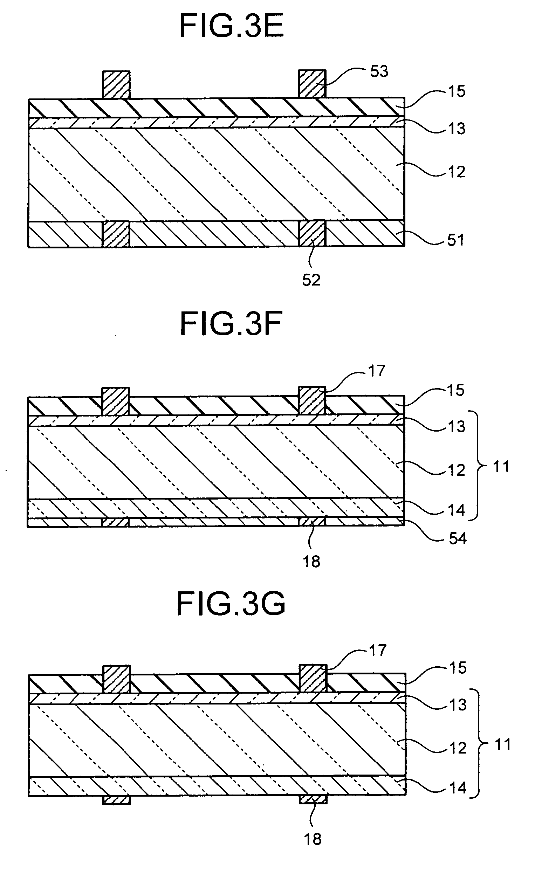

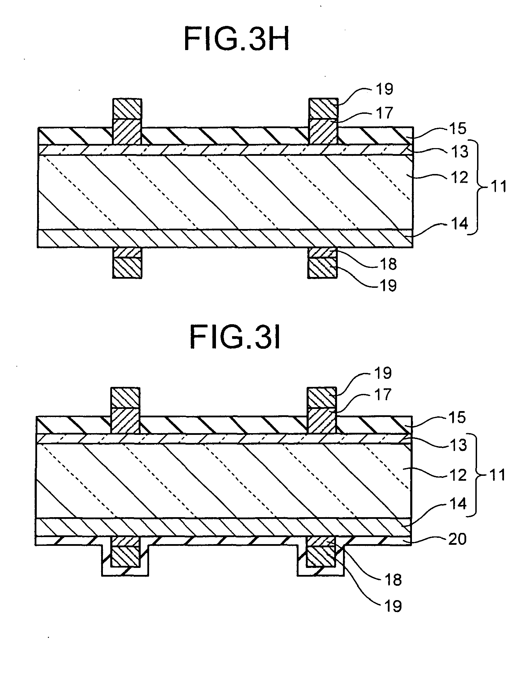

FIG. 3-4 is a cross-sectional view (4) schematically depicting an example of a method for manufacturing a solar cell according to the first embodiment of the present invention.
FIG. 3-5 is a cross-sectional view (5) schematically depicting an example of a method for manufacturing a solar cell according to the first embodiment of the present invention.
FIG. 3-6 is a cross-sectional view (6) schematically depicting an example of a method for manufacturing a solar cell according to the first embodiment of the present invention.
FIG. 3-7 is a cross-sectional view (7) schematically depicting an example of a method for manufacturing a solar cell according to the first embodiment of the present invention.
FIG. 3-8 is a cross-sectional view (8) schematically depicting an example of a method for manufacturing a solar cell according to the first embodiment of the present invention.
FIG. 3-9 is a cross-sectional view (9) schematically depicting an example of a method for manufacturing a solar cell according to the first embodiment of the present invention.

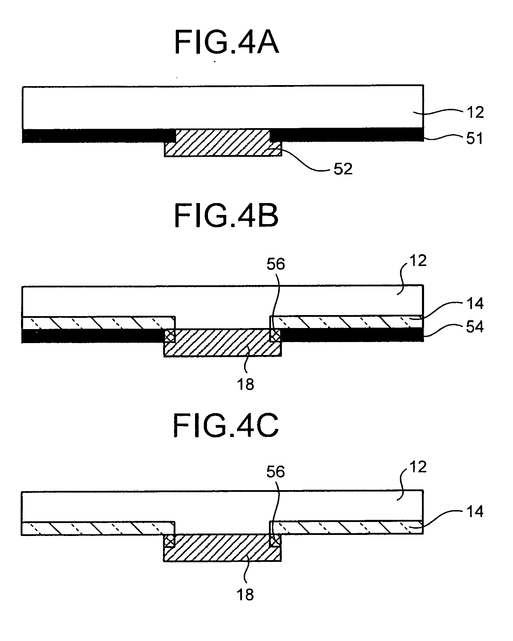

FIG. 4-1 is a cross-sectional view (1) schematically depicting a state of annealing a part near a back-surface silver electrode.
FIG. 4-2 is a cross-sectional view (2) schematically depicting a state of annealing a part near a back-surface silver electrode.
FIG. 4-3 is a cross-sectional view (3) schematically depicting a state of annealing a part near a back-surface silver electrode.

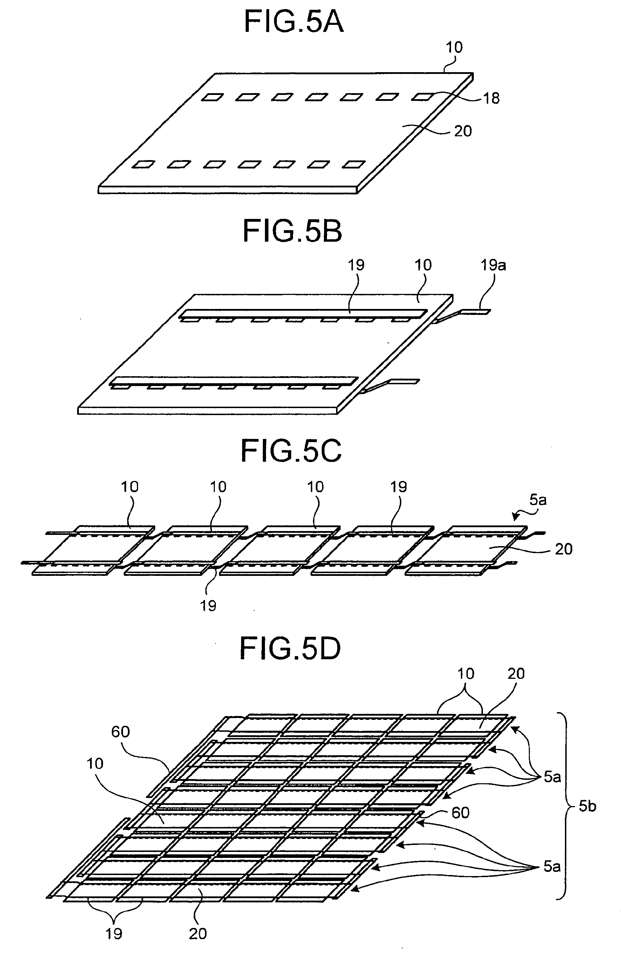

FIG. 5-1 is a perspective view (1) schematically depicting an example of a method for manufacturing a solar battery module constituted by plural solar cells.
FIG. 5-2 is a perspective view (2) schematically depicting an example of a method for manufacturing a solar battery module constituted by plural solar cells.
FIG. 5-3 is a perspective view (3) schematically depicting an example of a method for manufacturing a solar battery module constituted by plural solar cells.
FIG. 5-4 is a perspective view (4) schematically depicting an example of a method for manufacturing a solar battery module constituted by plural solar cells.

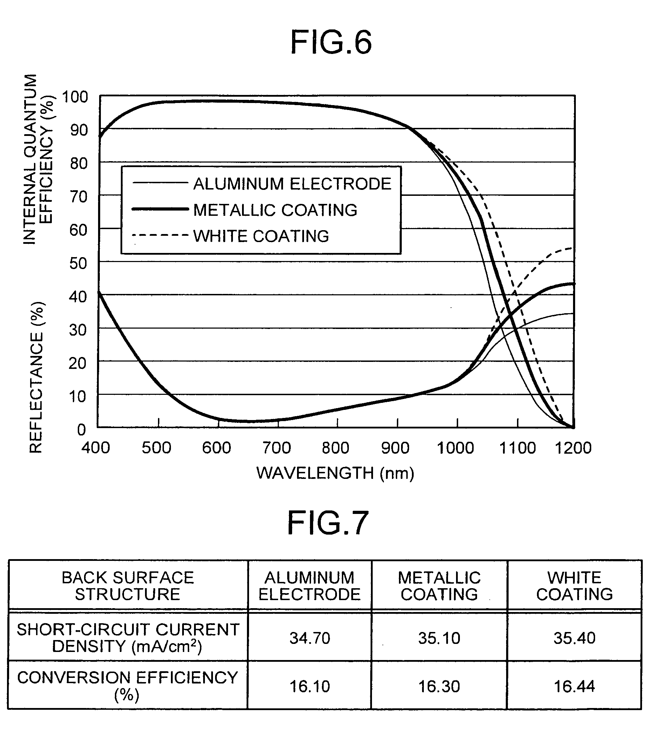

FIG. 6 depicts a wavelength dependency of internal quantum efficiency and a reflectance of a solar battery formed with a reflection layer according to the first embodiment and a solar battery formed by a conventional manufacturing method.
FIG. 7 is an example of a result of a short-circuit current density and conversion efficiency of a solar battery formed with a reflection layer according to the first embodiment and a solar battery formed by a conventional manufacturing method.

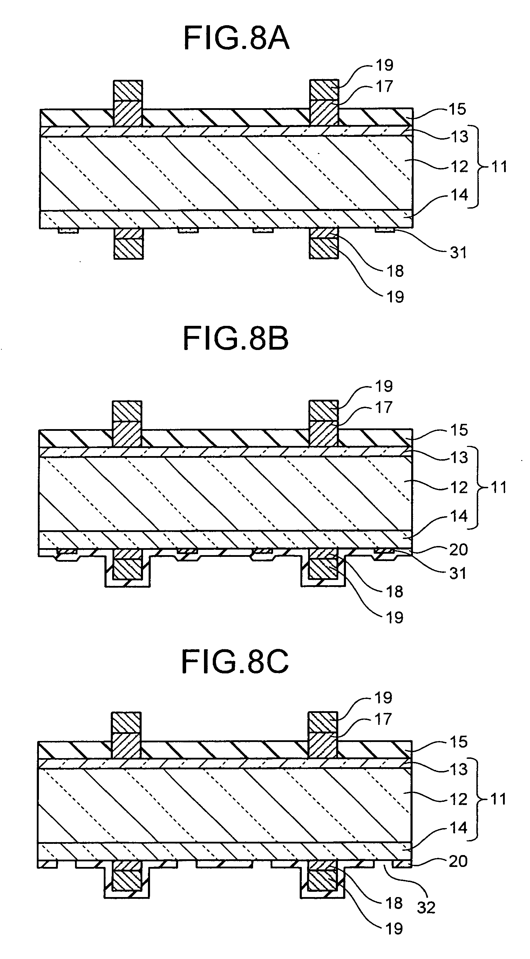

FIG. 8-1 is a cross-sectional view (1) schematically depicting an example of a method for manufacturing a solar battery module according to a second embodiment of the present invention.
FIG. 8-2 is a cross-sectional view (2) schematically depicting an example of a method for manufacturing a solar battery module according to a second embodiment of the present invention.
FIG. 8-3 is a cross-sectional view (3) schematically depicting an example of a method for manufacturing a solar battery module according to a second embodiment of the present invention.

### EXPLANATIONS OF LETTERS OR NUMERALS

- 5a, 5b: Unit
- 10: Solar cell
- 11: Semiconductor layer part
- 12: p-type silicon substrate
- 13: n-type diffusion layer
- 14: p+ layer
- 15: Reflection prevention film (silicon nitride film)
- 16: Front-surface silver grid electrode
- 17: Front-surface silver bus electrode
- 18: Back-surface silver electrode
- 19: Tab electrode
- 19a: Bulging portion
- 20: Reflection layer
- 31: Mask
- 51: Aluminum paste
- 52: Back-surface silver paste
- 53: Fornt-surface silver paste
- 54: Aluminum layer
- 56: Aluminum-silver alloy part
- 60: Lateral tab electrode

### BEST MODE(S) FOR CARRYING OUT THE INVENTION

Exemplary embodiments of a photovoltaic device and a method for manufacturing the same according to the present invention will be explained below in detail with reference to the accompanying drawings. In the following embodiments, while a solar battery is explained below as an example of the photovoltaic device, the present invention is not limited to the embodiments. Cross-sectional views of the solar battery used in the following embodiments are only schematic, and a relationship between the thickness and width of a layer and the ratio of thicknesses of layers are different from actual products.

### First embodiment.

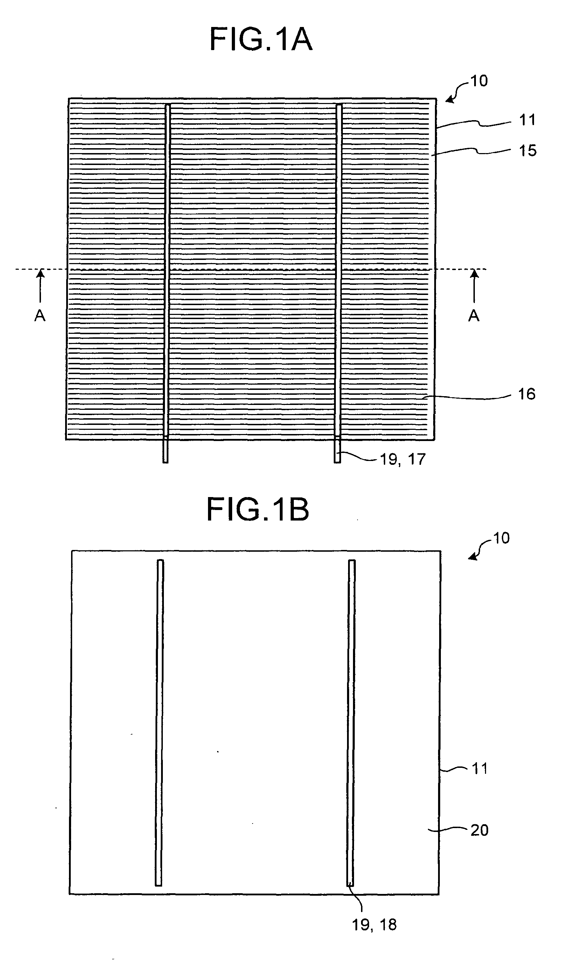

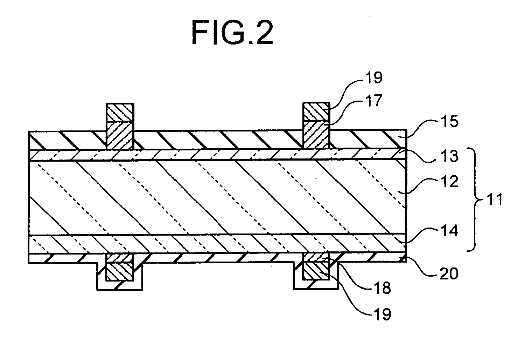

FIG. 1-1 is a plan view of an example of a solar cell according to a first embodiment of the present invention. FIG. 1-2 is a back surface view of the solar cell in FIG. 1-1. FIG. 2 is a cross-sectional view along a line A-A in FIG. 1-1. A solar cell 10 includes: a semiconductor layer part 11 that has a photoelectric conversion function, and includes a p-type silicon substrate 12 as a semiconductor substrate, an n-type diffusion layer 13 having an inverted conductivity type on a surface of the p-type silicon substrate 12, and a p+ layer (BSF layer) 14 containing a high concentration impurity; a reflection prevention film 15 that is provided on a light receiving surface of the semiconductor layer part 11 and prevents a reflection of incident light; plural front-surface silver grid electrodes 16 provided in parallel in a predetermined direction on the light receiving surface to locally collect electricity generated by the semiconductor layer part 11; front-surface silver bus electrodes 17 provided substantially orthogonally with the front-surface silver grid electrodes 16 to take out electricity collected by the front-surface silver grid electrodes 16; back-surface silver electrodes 18 that collect electricity generated by the semiconductor layer part 11; tab electrodes 19 that is provided on upper surfaces of the front-surface silver bus electrodes 17 and on the back-surface silver electrodes 18, and connects plural solar cells 10 in series; and a reflection layer 20 that reflects light incident from a light receiving surface side and transmitted through the semiconductor layer part 11, to the semiconductor layer part 11, and is formed on the entire surface of a p+ layer 14 on which the back-surface silver electrodes 18 are formed. The front-surface silver grid electrodes 16 and the front-surface silver bus electrodes 17 are collectively called front-surface silver electrodes.

The reflection layer 20 is configured by a material having a higher reflectance of light in a long-wavelength region of equal to or more than 1,000 nanometers, than a reflectance of aluminum formed at a back surface side of the p-type silicon substrate 12. The reflection layer 20 as a whole has insulation properties. For the reflection layer 20, there are a metallic coating material formed by having aluminum fine powders dispersed in an insulating resin, and a white coating material having minute titanium oxide mixed in an insulating resin.

The solar cell 10 having the above configuration generates holes and electrons when sunlight is irradiated from a light receiving surface side of the solar cell 10 to a pn-junction surface (a junction surface between the p-type silicon substrate 12 and the n-type diffusion layer 13) of the semiconductor layer part 11. The generated electrons move toward the n-type diffusion layer 13, and the holes move toward the p+ layer 14, by an electric field of a pn-junction part. Accordingly, electrons become excessive in the n-type diffusion layer 13, and the holes become excessive in the p+ layer 14. As a result, photovoltaic power is generated. This photovoltaic power is generated in a direction biasing a pn-junction in a forward direction. The front-surface silver bus electrodes 17 connected to the n-type diffusion layer 13 become minus poles, the back-surface silver electrodes 18 connected to the p+ layer 14 become plus poles, and a current flows to an external circuit (not shown).

Among the sunlight incident from the light receiving surface side of the solar cell 10, light not absorbed by the semiconductor layer part 11 is incident to the reflection layer 20. The reflection layer 20 can reflect the incident light, particularly, light in a long-wavelength region of equal to or more than 1,000 nanometers, more efficiently than when aluminum is used for back-surface electrodes. Therefore, a proportion of reflection light photoelectrically converted by the semiconductor layer part 11 can be increased.

A method for manufacturing a solar battery having the above configuration is explained next. FIGS. 3-1 to 3-9 are cross-sectional views schematically depicting an example of a method for manufacturing a solar cell according to the first embodiment of the present invention. FIGS. 4-1 to 4-3 are cross-sectional views schematically depicting a state of annealing a part near a back-surface silver electrode. FIGS. 5-1 to 5-4 are perspective views schematically depicting an example of a method for manufacturing a solar battery module constituted by plural solar cells.

In the case of a solar battery, a monocrystalline silicon substrate or a polycrystalline silicon substrate directly sliced from an ingot manufactured by a pulling method or a casting method, for example, is used in many cases. In this case, a substrate surface is etched by about 10 to 20 micrometers in depth using an alkali aqueous solution such as an aqueous potassium hydroxide and an aqueous sodium hydroxide, or a mixed liquid of hydrofluoric acid and nitric acid, to remove a substrate surface damage due to a scratch by a wiresaw used for slicing or the like and to remove a contamination in a wafer slicing process. Further, a process of cleaning by a mixed liquid of hydrochloric acid and hydrogen peroxide can be added to remove heavy metals such as iron adhered to a substrate surface. Thereafter, a texture structure (a fine concavo-convex structure) as a reflection prevention structure is often formed using an alkali aqueous solution such as an aqueous potassium hydroxide and an aqueous sodium hydroxide. The silicon substrate 12 to manufacture a solar cell is used in this way (FIG. 3-1). A p-type silicon substrate is assumed to be used here.

The n-type diffusion layer 13 is formed to form a pn-junction on the p-type silicon substrate 12 (FIG. 3-2). Specifically, phosphorous oxychloride (POCl₃) is used for a diffusion source of phosphorous, and is thermally diffused, thereby diffusing phosphorus (P) on a surface of the p-type silicon substrate 12 and forming the n-type diffusion layer 13 as an inverted conductivity type. Particularly when there is no design, the n-type diffusion layer 13 is formed on the entire surface of the p-type silicon substrate 12. A depth of the n-type diffusion layer 13 can be changed by controlling a diffusion temperature and time, and the n-type diffusion layer 13 of a depth in a range of about 0.3 to 0.5 micrometer is formed. A sheet resistance of the n-type diffusion layer 13 is about a few dozens of Q/□.

Thereafter, a resist is coated on only one principal surface of the silicon substrate 12. After removing by etching the n-type diffusion layer 13 on a surface not covered with the resist, the resist is removed by an organic solvent or the like. As a result, the p-type silicon substrate 12 on only one principal surface of which the n-type diffusion layer 13 is formed is obtained (FIG. 3-3).

As a method for forming the n-type diffusion layer 13, the n-type diffusion layer 13 can be formed on only one principal surface of the p-type silicon substrate 12 by coating a liquid coating material containing phosphorus such as PSG (Phospho-Silicate-Glass) on only the one principal surface using spin coating or the like and by diffusing the phosphorus by annealing in an appropriate condition. In this case, when there is a risk that the n-type diffusion layer 13 is also formed on the back surface of the silicon substrate 12, completeness can be increased by forming a resist on one principal surface and by removing by etching the n-type diffusion layer 13 formed on the other surface, in a similar manner to the above.

Next, a silicon nitride film functioning as the reflection prevention film 15 is formed on the n-type diffusion layer 13. This silicon nitride film decreases a surface reflectance of light incident to the solar cell 10, and can substantially increase a generated current (FIG. 3-4). An appropriate thickness of the silicon nitride film depends on a refractive index, and is about 700 to 900Å when the refractive index is about 1.9 to 2.1. This silicon nitride film is formed by a low-pressure CVD (Chemical Vapor Deposition) method and a plasma CVD method.

In the case of a thermal CVD method, a gas of dichlorosilane (SiCl₂H₂) and ammonium (NH₃) is used for a raw material in many cases, and a film is formed at a temperature equal to or higher than 700°C. According to this method, a raw gas is thermally decomposed at a high temperature, and therefore, hydrogen is little contained in a silicon nitride film. A composition ratio of Si and N becomes substantially Si₃N₄ as a stoichiometric composition, and the refractive index also becomes substantially in a range of 1.96 to 1.98. Therefore, a silicon nitride film like this has an extremely dense characteristic that a film quality (film thickness or refractive index) does not change even when a thermal process is added in a later process.

A mixed gas of SiH₄ and NH₃ is generally used for a raw gas to form a film by the plasma CVD method. The raw gas is decomposed by plasma, and a film is formed at a temperature of 300°C to 550°C. According to the plasma CVD method, a film is formed at a lower temperature than that by the thermal CVD method. Therefore, hydrogen contained in a raw gas is also contained in a silicon nitride film. Because gas decomposition is performed by plasma, a composition ratio of Si and N can be also changed greatly. Specifically, a composition ratio of Si, N and hydrogen can be changed by changing conditions such as a flow rate of a raw gas and a pressure and a temperature at the time of forming a film. As a result, a silicon nitride film of a refractive index in a range of 1.8 to 2.5 can be formed. When the film has this film quality, the refractive index sometimes changes from that immediately after a film is formed due to a phenomenon that the hydrogen is eliminated in a later process of adding a thermal process, such as a later electrode sintering process. In this case, a silicon nitride film necessary for the reflection prevention film 15 of a solar battery is formed by determining a film forming condition by considering beforehand a film quality change (that is, refractive index change) due to a thermal process in a later process.

Next, an aluminum paste 51 is coated on substantially the entire surface (a region excluding positions at which a back-surface silver paste 52 is coated) of a back surface of the p-type silicon substrate 12 by a screen printing method. The back-surface silver paste 52 is coated at predetermined positions (positions where the aluminum paste 51 is not coated) of the back surface of the p-type silicon substrate 12, and coated pastes are sequentially dried. Further, a front-surface silver paste 53 that becomes a front-surface silver electrode is coated on the reflection prevention film 15 (silicon nitride film) by the screen printing method, and is dried (FIG. 3-5). The aluminum paste 51 corresponds to a first conductivity-type-element-containing paste in the claims.

Thereafter, the substrate being processed as above-mentioned is sintered in a near-infrared furnace in a state that a mixed gas of oxygen and nitrogen in an oxygen concentration equal to or larger than 30% is passed for several minutes to ten-odd minutes at 700°C to 900°C (FIG. 3-6). As a result, aluminum is diffused as a p-type impurity from the aluminum paste 51 into the p-type silicon substrate 12 during the sintering, and the p+ layer 14 containing aluminum in high concentration is formed at the back surface side of the p-type silicon substrate 12. The aluminum paste 51 remaining without being used for diffusion in the sintering process becomes an aluminum layer 54. Portions of the back-surface silver paste 52 are simultaneously sintered, and become the back-surface silver electrodes 18 in a post-sintered state. A state of a boundary between the aluminum layer 54 and the back-surface silver electrodes 18 at the sintering time is described later.

As described above, a most part of the back surface needs to be formed with the p+ layer 14, and is occupied by the aluminum layer 54. For the aluminum paste 51, there is used a thick-film paste composition obtained by dispersing aluminum powders into an organic vehicle, or a thick-film paste composition obtained by dispersing aluminum powders and glass powders removable in a dilute hydrofluoric acid treating process performed later. Meanwhile, the back-surface silver electrodes 18 are formed at a part of the back surface as electrodes to mutually connect the solar cells 10 using copper foils or the like because a soldering is impossible on aluminum electrodes. Therefore, for a silver paste, there is used a thick-film paste composition obtained by dispersing silver powders and glass powders into an organic vehicle.

At a front-surface side, portions of the front-surface silver paste 53 configured by a glass component and silver frit become the front-surface silver electrodes 16 and 17 (the front-surface silver bus electrodes 17 are not shown) capable of melting and penetrating a silicon nitride film as the reflection prevention film 15 during sintering and electrically contacting (fire through) the n-type diffusion layer 13.

A part of the glass powders contained in the silver pastes 52 and 53 that become front-surface and back-surface electrodes is precipitated as molten glass at an electrode surface side after the sintering. Therefore, in directly soldering copper foils to electrically connect between solar cells 10 on the back-surface silver electrodes 18 and on the front-surface silver electrodes 16 and 17, silver electrodes need to be exposed by using a material containing an acid resin melting glass as a flux to remove the molten glass precipitated on the surface at the time of thermal application of a solder. Solar cells need to be cleaned with an exclusive flux remover solvent or the like at a subsequent modularization stage.

In the first embodiment, to remove a molten glass component precipitated at surface sides of the front-surface and back-surface silver electrodes 16 to 18 after sintering the electrodes, the solar cell 10 (the p-type silicon substrate 12) in a state of FIG. 3-6 is immersed into dilute hydrofluoric acid of about 1:10 to 1:500, preferably about 1:25 to 1:200, for several seconds to several minutes. In the immersion into the dilute hydrofluoric acid, the silver electrodes 16 to 18 formed on the front-surface and back-surface of the p-type silicon substrate 12 and the reflection prevention film 15 (silicon nitride film) do not lose their functions. That is, the reflection prevention film is not etched to the extent of changing a reflection prevention effect, and the silver electrodes 17 and 18 can hold mechanical strength of the tab electrodes 19 and the silver electrodes 17 and 18 in an assembly process after a subsequent soldering process. In the immersion, the molten glass is removed and silver electrode surfaces are exposed on surfaces of the front-surface and back-surface silver electrodes 17 and 18. Therefore, a flux of which reactivity is suppressed as compared with reactivity of a material containing an acid resin melting glass and which does not require cleaning at a modularization time can be used for a flux soldered with copper foils.

In a conventional solar cell, an aluminum electrode is formed using an aluminum paste capable of sufficiently obtaining adherence in this dilute-hydrofluoric-acid treating process and containing glass powders. However, in the present embodiment, the aluminum paste 51 is used containing no glass powers or containing glass powders capable of being removed in the dilute-hydrofluoric-acid treating process. Therefore, in the dilute-hydrofluoric-acid treating process, in removing molten glass powders formed on surfaces of the front-surface and back-surface silver electrodes 17 and 18 of the solar cell in the state of FIG. 3-6, the aluminum layer 54 can be removed in a state that the front-surface and back-surface silver electrodes 16 to 18 are kept formed (FIG. 3-7, FIG. 5-1).

A detail of a coating process of a back-surface-electrode forming paste to the dilute-hydrofluoric-acid treating process is explained with reference to FIGS. 4-1 to 4-3. In the coating process of a back-surface-electrode forming paste, the aluminum paste 51 is printed so as not to be coated at predetermined positions of the back surface of the silicon substrate 12, and the back-surface silver paste 52 is printed at positions where the aluminum paste 51 is not printed. In this case, actually, as shown in FIG. 4-1, the back-surface silver paste 52 is printed in not only a region where the p-type silicon substrate 12 is exposed but also such that the back-surface silver paste 52 is superimposed on the aluminum paste 51 at the surrounding contacting this region. At a sintering time, because the back-surface silver paste 52 does not contain aluminum, the p+ layer 14 is not formed on the p-type silicon substrate 12 contacting the back-surface silver electrode 18 as shown in FIG. 4-2 after the sintering. The aluminum layer 54 is formed at a portion coated with the aluminum paste 51. An aluminum-silver alloy part 56 is formed at a portion where the back-surface silver paste 52 is superimposed on the aluminum paste 51. Adhesion strength of the aluminum layer 54 is such that a scratch is recognized when touched by a soft H or HB pencil of which a value based on a test described in JIS K5400-8.4.1 or JIS K5400-8.4.2 is equal to or lower than H, for example. After the dilute-hydrofluoric-acid treating process, as described above, the aluminum layer 54 is removed, but the back-surface silver electrode 18 and the aluminum-silver alloy part 56 are left and are electrically connected to the p+ layer 14 at the aluminum-silver alloy part 56. The above explains a state of the boundary between the aluminum layer 54 and the back-surface silver electrode 18 at the sintering time after the aluminum layer 54 is removed.

Thereafter, the tab electrodes 19 made of copper formed to cover the front-surface silver bus electrodes 17 and extended to one end side of the front-surface silver bus electrodes 17 are formed. Portions of the tab electrodes 19 formed to extend to outside of the p-type silicon substrate 12 are called bulging portions 19a. The tab electrodes 19 made of copper are formed to connect the back-surface silver electrodes 18 formed at a predetermined interval on the back surface (FIGS. 3-8, 5-2).

The bulging portions 19a of the tab electrodes 19 formed at a surface side of the p-type silicon substrate 12 are soldered at forming positions of the tab electrodes 19 on the back surface of adjacent solar cells 10, thereby connecting the solar cells 10 in series to form a unit (FIG. 5-3). In the example of FIG. 5-3, five solar cells 10 connected in series form one unit 5a.

Further, the units 5a laid out in one direction are arranged in parallel with each other, and the tab electrodes 19 at ends of the units 5a are connected to lateral tab electrodes 60, thereby connecting a predetermined number of units 5a in series to form a flat unit 5b. For example, eight units 5a are arranged in parallel, that is, 40 solar cells 10 are arranged in series, to form one flat unit 5b in the present example. A coating material capable of forming a layer having a high reflectance after drying is coated at a back surface side of the flat unit 5b, and is dried, thereby forming the reflection layer 20 (FIGS. 3-9, 5-4). The reflection layer 20 is formed by applying injection coating or spray coating of a metallic coating material or a white coating material containing aluminum fine powders on the back surface side (on the p+ layer 14 formed with the tab electrodes 19) of the p-type silicon substrate 12. Thereafter, although not shown, the flat unit 5b formed with the reflection layer 20 is sandwiched by a transparent resin such as EVA (EthyleneVinyl-Acetate) to seal the flat unit 5b. Reinforced glass is adhered to the front surface side of the flat unit 5b, and a backfilm is adhered in laminae to the back surface side. Preferably, the backfilm has humidity resistance. The solar battery module is formed by the above process.

A result of an evaluation of characteristics of the solar battery according to the first embodiment is explained below. For a reflection layer of the solar battery according to the first embodiment, two kinds of layers are manufactured and evaluated: a layer coated with a metallic coating material containing aluminum powders; and a layer coated with a white coating material mixed with minute titanium oxide. For comparison, a solar battery having a back-surface aluminum electrode on the p+ layer formed by a conventional manufacturing method was also manufactured and evaluated.

FIG. 6 depicts a wavelength dependency of internal quantum efficiency and a reflectance of a solar battery formed with a reflection layer according to the first embodiment and a solar battery formed by the conventional manufacturing method. In FIG. 6, a lateral axis indicates a wavelength of light irradiated to a solar battery, and a vertical axis indicates an internal quantum efficiency and a reflectance. The reflectance in FIG. 6 indicates that of light when the light incident from atmosphere into a solar battery is reflected to the atmosphere again.

As shown in FIG. 6, a solar battery having metallic coating or white coating applied on its back surface has a higher reflectance and higher internal quantum efficiency in a long-wavelength region of equal to or larger than 1,000 nanometers than those of a conventional solar battery having a back-surface aluminum electrode. This shows that in the long-wavelength region of equal to or larger than 1,000 nanometers, a measured reflectance becomes high due to a reflectance effect from the reflection layer 20 on the back surface, and a part of light absorbed by an aluminum electrode on the back surface in a conventional structure is reflected and is transmitted within the silicon substrate 12 to improve the internal quantum efficiency. A reflection level depends on a composition of a coating material, and a reflectance of white coating tends to be higher than that of metallic coating.

FIG. 7 is an example of a result of a short-circuit current density and conversion efficiency of a solar battery formed with a reflection layer according to the first embodiment and a solar battery formed by the conventional manufacturing method. As shown in FIG. 7, as a characteristic of a solar battery, a solar battery having metallic coating or white coating applied on its back surface has a more improved short-circuit current density and more improved conversion efficiency than those of the conventional solar battery having a back-surface aluminum electrode.

According to the first embodiment, at a forming time of the front-surface and back-surface silver electrodes 16 to 18, the aluminum paste 51 not containing glass powders or containing glass powders melted by dilute hydrofluoric acid treatment is coated and sintered in a region not formed with the back-surface silver electrode 18. Therefore, the front-surface and back-surface silver electrodes 16 to 18 can be formed simultaneously by sintering, and the p+ layer 14 can be formed on the back surface of the silicon substrate 12. Further, by the subsequent dilute hydrofluoric acid treatment, the aluminum layer 54 formed on the back surface and a molten glass film precipitated on the front-surface and back-surface silver electrodes 16 to 18 can be removed without degrading the performance of the reflection prevention film 15 (silicon nitride film). Accordingly, a conventional inconvenience can be solved such as the front-surface and back-surface silver electrodes 16 to 18 cannot be simultaneously formed to remove the aluminum layer 54 and a process of protecting the front-surface and back-surface silver electrodes 16 and 17 increases. A solar battery formed in this way can increase a reflectance on the back surface in a long wavelength of equal to or larger than 1,000 nanometers, and can increase power generation efficiency.

### Second embodiment.

In the first embodiment, as shown in FIG. 5-4, solar cells are sealed with EVA or the like in a state that 40 solar cells are assembled in series. Depending on a material of a reflection layer, adhesion strength with EVA cannot be sufficiently obtained when modularized although a reflection effect is high. In a second embodiment, a structure of a solar cell capable of sufficiently obtaining adhesion strength between a back surface side of a solar cell and EVA even when such as reflection layer is used and a method for manufacturing the solar cell are explained.

FIGS. 8-1 to 8-3 are cross-sectional views schematically depicting an example of a method for manufacturing a solar battery module according to the second embodiment of the present invention. In a similar manner to that of the first embodiment explained with reference to FIGS. 3-1 to 3-8, the n-type diffusion layer 13, a silicon nitride film for the reflection prevention film 15, and the front-surface silver electrodes 16 and 17 are formed at the light receiving surface side of the p-type silicon substrate 12, and the p+ layer 14 and the back-surface silver electrodes 18 are formed at the back surface side. In this case, the aluminum layer 54 used to form the p+ layer 14 is removed by the dilute hydrofluoric acid treatment. The tab electrodes 19 made of copper are formed on the front-surface silver bus electrodes 17. The tab electrodes 19 made of copper are formed to connect the back-surface silver electrodes 18. The bulging portions 19a of the tab electrodes 19 formed on the front-surface silver bus electrodes 17 are caused to contact to the tab electrodes 19 at a backside of other adjacent solar cells 10.

Lattice-shaped masks 31 are mounted at the back surface side of each of the solar cells 10 (FIG. 8-1), and spray coating is applied on the reflection layer 20 in this state (FIG. 8-2). Accordingly, portions mounted with the masks 31 are not coated, and regions not coated with the reflection layer 20 are formed in a lattice shape on the p+ layer 14. The masks 31 are removed in this state (FIG. 8-3). Consequently, regions 32 exposed with the p+ player are formed at the portions where the masks 31 are formed. Thereafter, as explained in the first embodiment, in the solar cell 10, the flat unit 5b is sandwiched by a transparent resin such as EVA to seal the flat unit 5b. Reinforced glass for module is adhered to the front surface side of the flat unit 5b, and a backfilm is adhered in laminae to the back surface side, thereby forming a solar battery module.

Accordingly, the reflection layer 20 having the regions 32 exposed with the surface of the p+ layer 14 is formed in a lattice shape on the p+ layer 14 on the back surface of the solar cell 10. When the masks 31 mounted on the back surface are in a lattice shape of an interval of 10 millimeters, each mask having a 1-mm width, portions not coated become smaller than 10% of a total area. Consequently, reflection effect is little lost, and adhesion strength is sufficient. In this way, preferably, an area of the regions 32 not formed with the reflection layer 20 is smaller than 10% of a total area of the back surface. Although it is explained above that the regions 32 not formed with the reflection layer 20 are in a lattice shape, the shape is not limited to this.

As explained above, because the regions 32 not formed with the reflection layer 20 are provided on the p+ layer 14 and because a transparent resin such as EVA can be directly adhered to these regions 32, sufficient adhesion strength can be obtained between the solar cell 10 and a transparent resin such as EVA, and high power-generation efficiency can be obtained by a back-surface reflection.

According to the second embodiment, because the regions 32 not formed with the reflection layer 20 are formed on the back surface of the solar cell 10 and because a transparent resin such as EVA is coated to the regions 32 exposed with the p+ layer 14, adhesion strength between the p+ layer 14 and the transparent resin can be increased. By setting the regions 32 exposed with the p+ layer 14 smaller than 10% of a total area (that is, equal to or more than 90% of a total area of the back surface), adhesion strength between the p+ layer 14 and the transparent resin can be increased without losing the effect of a reflection by the reflection layer 20. When the reflection layer 20 is not formed on the back surface, tensile strength of the backfilm adhered to the transparent resin (in this case, adhesion strength between the solar cell 10 and EVA) reaches 1 kgf per 1 square centimeter. At this value, the strength is substantially maintained when the regions 32 not formed with the reflection layer 20 occupy 100 to 5% of the region. When the region exceeds 5%, the tensile strength decreases to equal to or smaller than 0.8 kgf. Therefore, to maintain the tensile strength, it is necessary that the regions 32 not formed with the reflection layer 20 occupy approximately 10% of the region.

Although forming of the n-type diffusion layer 13 on the p-type silicon substrate 12 has been explained above as an example, the present invention can be similarly applied to a case of an inverted conductivity type. Further, the present invention can be also applied to semiconductor substrates in general, not only to silicon substrates.

### INDUSTRIAL APPLICABILITY

As described above, the photovoltaic device according to the present invention is useful for a light receiving element such as a photodiode and a solar battery.

## Claims

1. A photovoltaic device comprising:
a first conductivity-type semiconductor substrate;
a first diffusion layer having a second conductivity-type impurity diffused at a light incident surface side of the semiconductor substrate;
a front surface electrode formed on the first diffusion layer;
a second diffusion layer of a first conductivity type formed on a back surface opposite to a light incident surface side of the semiconductor substrate;
back-surface electrodes formed at predetermined positions on the second diffusion layer; and
a reflection layer made of an insulating material that reflects light formed on the second diffusion layer on which the back-surface electrodes are formed.

2. The photovoltaic device according to claim 1, wherein the reflection layer is formed on an entire surface of the second diffusion layer on which the back-surface electrodes are formed.

3. The photovoltaic device according to claim 1, wherein the reflection layer is formed to cover equal to or more than 90% of a total area of the second diffusion layer on which the back-surface electrodes are formed.

4. The photovoltaic device according to claim 1, wherein the reflection layer is an insulation film that reflects whole or a part of a wavelength region that contributes to a photoelectric conversion in a semiconductor layer part including the semiconductor substrate and the first diffusion layer.

5. The photovoltaic device according to claim 4, wherein the reflection layer is an insulation film containing aluminum powders or titanium oxide powders.

6. A method for manufacturing a photovoltaic device comprising:
a first diffusion-layer forming process of forming a first diffusion layer by diffusing a second conductivity-type impurity at a light incident surface side of a first conductivity-type semiconductor substrate;
a paste coating process of coating a paste for front surface electrodes of a predetermined shape on the first diffusion layer, and coating a first conductivity-type-element-containing paste containing an element of a first conductivity type having an opening at a predetermined position on a back surface corresponding to the light incident surface side of the semiconductor substrate and coating a paste for back-surface electrodes to cover the opening of the first conductivity-type-element-containing paste;
a sintering process of sintering the pastes, forming a second diffusion layer having a first conductivity-type impurity concentration higher than that of the semiconductor substrate on a back surface of the semiconductor substrate and a first conductivity-type impurity layer of which the first conductivity-type-element-containing paste not diffused is sintered, and forming front surface electrodes and back-surface electrodes on the first diffusion layer and on the back surface of the first semiconductor substrate, respectively;
a removing process of removing only the first conductivity-type impurity layer;
a tab-electrode forming process of forming tab electrodes on the front surface electrodes and the back-surface electrodes; and
a reflection-layer forming process of forming a reflection layer made of an insulating material that reflects light, on a back surface of the semiconductor substrate on which the tab electrodes are formed.

7. The method for manufacturing a photovoltaic device according to claim 6, wherein the first conductivity-type-element-containing paste used in the paste coating process does not contain glass powders.

8. The method for manufacturing a photovoltaic device according to claim 6, wherein
the paste for front surface electrodes and the paste for back-surface electrodes used in the paste coating process are pastes containing silver, and the first conductivity-type-element-containing paste is a paste containing aluminum and not containing glass powders, and
in the removing process, an aluminum layer as the first conductivity-type impurity layer is selectively removed by using hydrofluoric acid diluted by pure water at a rate of 1:10 to 1:500.

9. The method for manufacturing a photovoltaic device according to claim 8, wherein in the aluminum layer as the first conductivity-type impurity layer sintered in the sintering process, a scratch is recognized when touched by a soft pencil of which a value based on a test described in JIS K5400-8.4.1 or JIS K5400-8.4.2 is equal to or lower than H.

10. The method for manufacturing a photovoltaic device according to claim 6, wherein in the reflection-layer forming process, the reflection layer is formed on an entire surface of the second diffusion layer on which the back-surface electrodes are formed.

11. The method for manufacturing a photovoltaic device according to claim 6, wherein in the reflection-layer forming process, the reflection layer is formed to cover equal to or more than 90% of a total area of the second diffusion layer on which the back-surface electrodes are formed.

12. The method for manufacturing a photovoltaic device according to claim 6, wherein the reflection layer is an insulation film that reflects whole or a part of a waveform region that contributes to a photoelectric conversion in a semiconductor layer part including the semiconductor substrate and the first diffusion layer.

13. The method for manufacturing a photovoltaic device according to claim 12, wherein the reflection layer is formed by a coating material mixed with aluminum powders or titanium oxide powders.

14. The method for manufacturing a photovoltaic device according to claim 13, wherein in the reflection-layer forming process, the coating material is coated by an injection coating or a spray coating on the semiconductor substrate on which the tab electrodes are formed.
